# FASCICULE DE BREVET EUROPEEN

(11) **EP 0 618 761 B1**
(45) Date de publication et mention de la délivrance du brevet: **18.12.1996**
(21) Numéro de dépôt: 94400633.7
(22) Date de dépôt: 24.03.1994
(51) Int. Cl.: H05K 7/14, F16B 5/02, H04N 1/028

(54) **Procédé et dispositif de fixation d'un détecteur optique d'un appareil tel qu'un télécopieur**
Verfahren und Vorrichtung zur Befestigung eines optischen Sensors z.B. eines Faksimilegerätes
Method and device for fastening an optical sensor of an apparatus such as a facsimile device

(30) Priorité: 30.03.1993 FR 9303664
(43) Date de publication de la demande: 05.10.1994
(73) Titulaire: SOCIETE D'APPLICATIONS GENERALES D'ELECTRICITE ET DE MECANIQUE SAGEM, F-75783 Paris Cédex 16 (FR)
(72) Inventeur: Vegeais, Patrick, F-78112 Fourqueux (FR); Cavarero, Eric, F-95000 Cergy (FR)
(74) Mandataire: Bloch, Gérard

(56) Documents cités:
- EP-A- 0 491 500
- US-A- 4 309 856

## Description

La présente invention concerne un procédé et un dispositif de fixation sur le bâti d'un appareil tel qu'un télécopieur, d'une carte support d'un détecteur optique à circuit à transfert de charges. Un tel procédé et un tel dispositif sont décrits dans EP-A-0 491 500.

Dans un tel appareil, un détecteur optique telle qu'une barrette CCD reçoit l'image d'une feuille de papier focalisée à l'aide d'un objectif, afin d'effectuer une analyse de cette image. Le détecteur optique est monté sur une carte support, elle-même fixée sur le bâti de l'appareil perpendiculairement à l'axe optique de l'objectif.

Il est donc important, afin de centrer l'image sur le détecteur, de positionner convenablement la carte support dans son propre plan, la mise au point de l'image sur le détecteur s'effectuant indépendamment par translation de l'objectif parallèlement à son axe optique.

Jusqu'à présent la carte support des détecteurs optiques était fixée sur le bâti de l'appareil à l'aide de vis et de rondelles, les vis traversant des trous formés dans la carte et les rondelles étant interposées entre la carte et les têtes des vis.

Un tel agencement présentait l'inconvénient que, lors du serrage des vis, un couple de rotation était transmis à la carte par l'intermédiaire de la rondelle, ce qui provoquait un déplacement de la carte dans son plan. Or, un très faible déplacement peu conduire à un décentrage conséquent de l'image étant donné que, dans les barrettes CCD couramment utilisées, la largeur d'un pixel est de l'ordre de 10 micromètres. Le réglage s'effectuait donc par approximations successives sur les différentes vis de serrage. Un tel réglage était donc long et complexe et par conséquent coûteux.

La présente invention vise à pallier ces inconvénients.

A cet effet, l'invention a tout d'abord pour objet un procédé de fixation sur le bâti d'un appareil tel qu'un télécopieur, d'une carte support d'un détecteur optique à circuit à transfert de charges, caractérisé par le fait qu'il comprend l'étape consistant à appliquer ladite carte sur une surface d'appui dudit bâti à l'aide d'un organe d'appui mobile sensiblement perpendiculairement au plan de ladite carte et n'ayant pas de liberté de se mouvoir parallèlement à celui-ci.

L'organe d'appui n'ayant pas de liberté de mouvement dans le plan de la carte support, l'application de la carte sur la surface d'appui du bâti est effectuée uniquement par un effort perpendiculaire au plan de la carte et par conséquent sans mouvement parasite dans le plan de celle-ci. Il en résulte un réglage optimal, une simplification de l'opération de réglage et par conséquent un gain en temps de réglage.

Dans un mode de mise en oeuvre particulier de l'invention, l'organe d'appui est déplacé sensiblement perpendiculairement au plan de la carte par actionnement d'un organe de serrage rotatif sans contact avec ladite carte.

La fixation de la carte s'effectue par conséquent avec des moyens conventionnels tels que des vis mais, du fait de l'absence de contact entre ces vis et la carte, celle-ci ne subit aucun couple de rotation lors du serrage.

La présente invention a également pour objet un dispositif de fixation sur le bâti d'un appareil tel qu'un télécopieur, d'une carte support d'un détecteur optique à circuit à transfert de charges, caractérisé par le fait qu'il comprend une surface d'appui formée sur ledit bâti et un organe d'appui mobile sensiblement perpendiculairement à ladite surface d'appui et n'ayant pas de liberté de se mouvoir parallèlement à celle-ci.

Plus particulièrement, l'organe d'appui peut comprendre une languette élastatique réalisée d'une seule pièce avec ledit bâti.

Dans un mode de réalisation particulier, le dispositif selon l'invention comprend des moyens de serrage rotatifs pour déplacer ledit organe d'appui sensiblement perpendiculairement à ladite surface d'appui.

Ces moyens de serrage rotatifs peuvent en particulier être agencés pour traverser la carte sans frottement.

Les moyens de serrage rotatifs peuvent notamment comprendre une vis traversant ledit organe d'appui en coopérant avec un écrou bloqué en rotation dans un logement formé dans le bâti.

On décrira maintenant à titre d'exemple non limitatif, un mode de réalisation particulier de l'invention en référence aux dessins annexés dans lesquels :

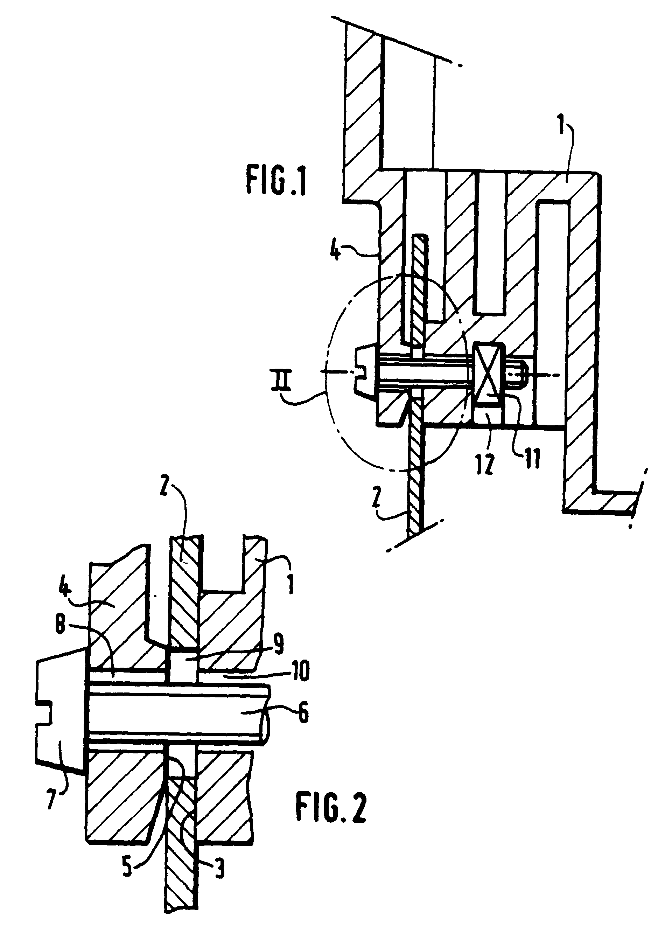

- la figure 1 est une vue en coupe d'un dispositif selon l'invention et
- la figure 2 est une vue agrandie du détail II de la figure 1.

Les figures montrent le bâti 1 d'un appareil tel qu'un télécopieur, ce bâti portant notamment une carte support 2 d'un détecteur optique constitué par exemple d'une barrette CCD (non représentée).

Le bâti 1 comporte un corps formant une surface d'appui 3 pour la carte 2 et, réalisée d'une seule pièce avec lui, une languette élastique 4 présentant elle-même une zone d'appui 5 permettant de presser la carte 2 contre la surface d'appui 3 du bâti 1.

La languette 4 possède une rigidité suffisante dans son plan (parallèle au plan de la carte 2) pour ne posséder aucune liberté de mouvement autre qu'un mouvement de flexion, tel que sa zone d'appui 5 se déplace sensiblement perpendiculairement au plan de la carte 2 et à la surface d'appui 3.

Une vis 6 possède une tête 7 en appui sur la surface extérieure de la languette 4 et traverse un trou 8 formé dans cette languette et un trou 9 formé dans la carte support 2.

Le trou 8 possède un diamètre suffisant pour permettre à la vis 6 de tourner librement, et le trou 9 possède un diamètre encore plus grand de manière que, quelle que soit la position de la vis 6 dans le trou 8, elle n'ait aucun contact avec les bords du trou 9 de la plaque 2.

La vis 6 traverse par ailleurs un trou 10 formé dans le corps du bâti 1 et son extrémité est engagée dans un écrou de serrage 11 possédant une forme en plan carrée et logé dans une rainure de blocage 12 de forme correspondante, permettant d'éviter sa rotation.

La carte 2 est donc maintenue en appui sur la surface d'appui 3 par un serrage de la vis 6 qui amène la languette élastique 4 à appliquer la carte sur la surface d'appui.

La vis 6 n'étant pas en contact avec la carte 2, celle-ci ne subit que l'effort de compression perpendiculaire à son plan exercé par la languette 4, lequel effort de compression ne provoque aucun mouvement parasite.

Une pluralité de dispositifs tels que décrits ci-dessus, disposés en différents endroits de la carte 2, permettent par conséquent de la fixer au bâti. Le réglage de la carte 2 dans son plan est effectué préalablement, après quoi les vis 6 sont serrées sans altérer ce réglage.

## Revendications

1. Procédé de fixation sur le bâti (1) d'un appareil tel qu'un télécopieur, d'une carte support (2) d'un détecteur optique à circuit à transfert de charges, caractérisé par le fait qu'il comprend l'étape consistant à appliquer ladite carte sur une surface d'appui (3) dudit bâti à l'aide d'un organe d'appui (4) mobile sensiblement perpendiculairement au plan de ladite carte et n'ayant pas de liberté de se mouvoir parallèlement à celui-ci.

2. Procédé selon la revendication 1, dans lequel l'organe d'appui est déplacé sensiblement perpendiculairement au plan de la carte par actionnement d'un organe de serrage rotatif (6) sans contact avec ladite carte.

3. Dispositif de fixation sur le bâti (1) d'un appareil tel qu'un télécopieur, d'une carte support (2) d'un détecteur optique à circuit à transfert de charges, caractérisé par le fait qu'il comprend une surface d'appui (3) formée sur ledit bâti, et un organe d'appui (4) mobile sensiblement perpendiculairement à ladite surface d'appui et n'ayant pas de liberté de se mouvoir parallèlement à celle-ci.

4. Dispositif selon la revendication 3, dans lequel ledit organe d'appui comprend une languette élastique réalisée d'une seule pièce avec ledit bâti.

5. Dispositif selon l'une quelconque des revendications 3 et 4, comprenant des moyens de serrage rotatifs (6) pour déplacer ledit organe d'appui sensiblement perpendiculairement à ladite surface d'appui.

6. Dispositif selon la revendication 5, dans lequel lesdits moyens de serrage rotatifs sont agencés pour traverser ladite carte sans frottement.

7. Dispositif selon l'une quelconque des revendications 5 et 6, dans lequel lesdits moyens de serrage rotatifs comprennent une vis traversant ledit organe d'appui et coopérant avec un écrou bloqué en rotation dans un logement formé dans le bâti.

## Patentansprüche

1. Verfahren zum Befestigen einer Trägerkarte (2) eines optischen Detektors mit Ladungsübertragungsschaltung auf dem Rahmen (1) eines Gerätes wie etwa eines Facsimile-Gerätes, gekennzeichnet durch den Schritt, die genannte Karte auf einer Auflagefläche (3) des Rahmens mittels eines Stützorgans (4) auf zu stützen, welches im wesentlichen senkrecht zur Ebene der genannten Karte beweglich ist und keine Bewegungsfreiheit parallel zu der Karte besitzt.

2. Verfahren nach Anspruch 1, dadurch gekennzeichnet, daß das Stützorgan durch Betätigung eines eines drehbaren Spannorgans (6) ohne Kontakt mit der Karte im wesentlichen senkrecht zur Ebene der Karte verlagert wird.

3. Vorrichtung zum Befestigen einer Trägerkarte (2) eines optischen Detektors mit Ladungsübertragungsschaltung auf dem Rahmen (1) eines Gerätes wie etwa eines Facsimile-Gerätes, gekennzeichnet durch eine auf dem Rahmen ausgebildete Auflagefläche (3) und ein Stützorgan (4), das im wesentlichen senkrecht zu der genannten Auflagefläche beweglich ist und keine Bewegungsfreiheit parallel dazu besitzt.

4. Vorrichtung nach Anspruch 3, dadurch gekennzeichnet, daß das Stützorgan eine elastische Zunge aufweist, die einstückig mit dem Rahmen hergestellt ist.

5. Vorrichtung nach Anspruch 3 oder 4, gekennzeichnet durch drehbare Spannmittel (6) zum Verlagern des Stützorgans im wesentlichen senkrecht zu der Auflagefläche.

6. Vorrichtung nach Anspruch 5, dadurch gekennzeichnet, daß die drehbaren Spannmittel so eingerichtet sind, daß sie ohne Reibung durch die Karte hindurchgehen.

7. Vorrichtung nach Anspruch 5 oder 6, dadurch gekennzeichnet, daß die drehbaren Spannmittel eine Schraube aufweisen, die durch das Stützorgan hindurchgeht und mit einer Mutter zusammenwirkt, die gegen Verdrehen in einem im Rahmen ausgebildeten Aufnahmeraum blockiert ist.

## Claims

1. Method for fastening on the frame (1) of an apparatus, such as a facsimile device, a support plate (2) of an optical detector with a charge couple circuit, characterised in that it comprises the step of applying the said plate to an abutment surface (3) of the said frame with the aid of an abutment member (4) which can move substantially perpendicular to the plane of the said plate and has no freedom of movement parallel to the said plane.

2. Method according to claim 1, wherein the abutment member is displaced substantially perpendicular to the plane of the plate by actuation of a rotational tightening member (6) without contact with the said plate.

3. Device for fastening on the frame (1) of an apparatus, such as a facsimile device, a support plate (2) of an optical detector with a charge couple circuit, characterised in that it comprises an abutment surface (3) formed on the said frame, and an abutment member (4) which can move substantially perpendicular to the said abutment surface and has no freedom of movement parallel to the said abutment surface.

4. Device according to claim 3, wherein the said abutment member comprises an elastic tongue produced as one piece with the said frame.

5. Device according to either of claims 3 and 4, comprising rotational tightening means (6) to displace the said abutment member substantially perpendicular to the said abutment surface.

6. Device according to claim 5, wherein the said rotational tightening means are arranged to pass through the said plate without friction.

7. Device according to either of claims 5 and 6, wherein the said rotational tightening means comprise a screw passing through the said abutment member and cooperating with a nut which is rotationally fixed in a recess formed in the frame.
